# EUROPEAN PATENT APPLICATION

(11) **EP 3 780 374 A1**
(43) Date of publication of application: **17.02.2021**
(21) Application number: 18914047.8
(22) Date of filing: 11.04.2018
(51) Int. Cl.: H02M 7/48, B60L 3/00

(54) **MACHINE PROTECTION DEVICE AND MACHINE PROTECTION METHOD**

(71) Applicant: NISSAN MOTOR CO., LTD., Yokohama-shi, Kanagawa 221-0023 (JP)
(72) Inventor: NAMIKI, Kazushige, Atsugi-shi, Kanagawa 243-0123 (JP); ABE, Keita, Atsugi-shi, Kanagawa 243-0123 (JP); EDUMI, Masahiko, Atsugi-shi, Kanagawa 243-0123 (JP); KAWAGUCHI, Shinji, Atsugi-shi, Kanagawa 243-0123 (JP)
(74) Representative: Hoefer & Partner Patentanwälte mbB
(86) International application number: PCT/JP2018/015297
(87) International publication number: WO 2019/198184

(57) **Abstract**

A device protection apparatus comprises, a refrigerant temperature sensor for detecting a temperature of a refrigerant used for cooling a device including a heat-generation part, a plurality of device temperature sensors for detecting a temperature of the device, a controller that applies drive limitation to the device based on a detected refrigerant temperature detected by the refrigerant temperature sensor and a detected temperature detected by the device temperature sensors. The controller, specifies the detected temperature higher than the lowest detected temperature among the temperatures detected by the plurality of the device temperature sensors, as a detected device temperature, calculates a temperature difference between the detected refrigerant temperature and the detected device temperature, applies the drive limitation to the device when the temperature difference is higher than a temperature difference threshold value, and applies the drive limitation to the device when the detected device temperature is higher than a temperature threshold value.

## Description

The present invention relates to the device protection apparatus and the device protection method.

### [BACKGROUND ART]

A known method includes a step for detecting a inverter temperature by a temperature sensor, a step for calculating an amount of temperature change, and a step correcting the invertor temperature when the amount of temperature change is higher than a threshold value. In addition, the known method includes a step for smoothing the inverter temperature after correction, and a step for setting a load-limiting rate to limit a torque of a motor when a temperature after smoothing is higher than a upper limit temperature. (Patent Document 1).

### [PRIOR ART DOCUMENT]

### [PATENT DOCUMENT]

[PATENT DOCUMENT 1] JP2006-230037A

### [SUMMARY OF THE INVENTION]

### [PROBLEM TO BE SOLVED BY THE INVENTION]

However, when an ambient temperature is high, the torque limit is not applied to an appropriate timing, and the heat-generating part becomes high temperature.

An object to be solved by the present invention is to provide a the device protection apparatus and the device protection method capable of suppressing the temperature rise of the heating portion.

### [MEANS FOR SOLVING PROBLEM]

The present invention, from among the temperatures detected by the plurality of the device temperature sensor, specifies a detected temperature high than the lowest detected temperature as the detected device temperature, calculates the temperature difference between the detected refrigerant temperature and the detected device temperature, applies the drive limitation to a device when the temperature difference is higher that a predetermined temperature difference threshold value, and applies the drive limitation to a device when the detected device temperature is higher than a predetermined temperature threshold value, to solve the above problem.

### [EFFECT OF THE INVENTION]

According to the present invention, it is possible to suppress the temperature rise of the heating portion.

### [BRIEF DESCRIPTION OF DRAWING(S)]

[Fig. 1] Fig. 1 is a block diagram of a drive system including an the device protection apparatus according to the present embodiment.
[Fig. 2] Fig. 2 is a circuit diagram of an inverter circuit included in a power supply, a load, and a power converter.
[Fig. 3] Fig. 3 is a flow chart illustrating a control flow of the device protection apparatus.
[Fig. 4A] Fig. 4A is a graph showing the temperature properties when the environmental temperature is low temperature (T_{L}).
[Fig. 4B] Fig. 4B is a graph showing the temperature properties when the environmental temperature is low temperature (T_{L}).
[Fig. 5A] Fig. 5A is a graph showing the temperature characteristics when the environmental temperature is high (T_{H}).
[Fig. 5B] Fig. 5B is a graph showing the temperature properties when the environmental temperature is high temperature (T_{H}).
[Fig. 6A] Fig. 6A is a graph showing the temperature properties when the environmental temperature is low temperature (T_{L}).
[Fig. 6B] Fig. 6B is a graph showing the temperature properties when the environmental temperature is low temperature (T_{L}).
[Fig. 7A] Fig. 7A is a graph showing the temperature properties when the environmental temperature is high temperature (T_{H}).
[Fig. 7B] Fig. 7B is a graph showing the temperature properties when the environmental temperature is high temperature (T_{H}).
[Fig. 8] Fig. 8 is a flow chart illustrating a control flow of controller of the device protection apparatus according to another embodiment of the present invention.
[Fig. 9] Fig. 9 is a graph showing the temperature change with respect to time when an abnormality occurs in the device temperature sensor 21u, 21v, and 21w.
[Fig. 10] Fig. 10 is a graph showing the relationship between the motor rotation speed and the temperature difference (ΔTp).
[Fig. 11] Fig. 11 is a graph showing the relationship between the motor angle and the temperature difference (ΔTp).
[Fig. 12] Fig. 12 is a graph showing the relationship between the motor torque and the temperature difference (ΔTp).
[Fig. 13] Fig. 13 is a flowchart illustrating a control flow of controller of the device protection apparatus according to another embodiment of the present invention.

### [Mode(s) for Carrying out the Invention]

Hereinafter, embodiments of the present invention will be described with reference to the drawings. The device protection apparatus according to the present embodiment is a device for suppressing the temperature rise of the device including the heat-generation part. The device protection apparatus is provided in the drive system mounted on vehicle, for example, and controls the temperature of the device contained in the drive system while suppressing the temperature rise of the device.

In the following illustrations, an example in which a device protection apparatus is provided in a drive system for a vehicle will be described. The device protection apparatus does not necessarily need to be provided in the drive system, it may be provided in another system including a heat generating portion. The device protection apparatus may be provided not only in the vehicle but also in another device.

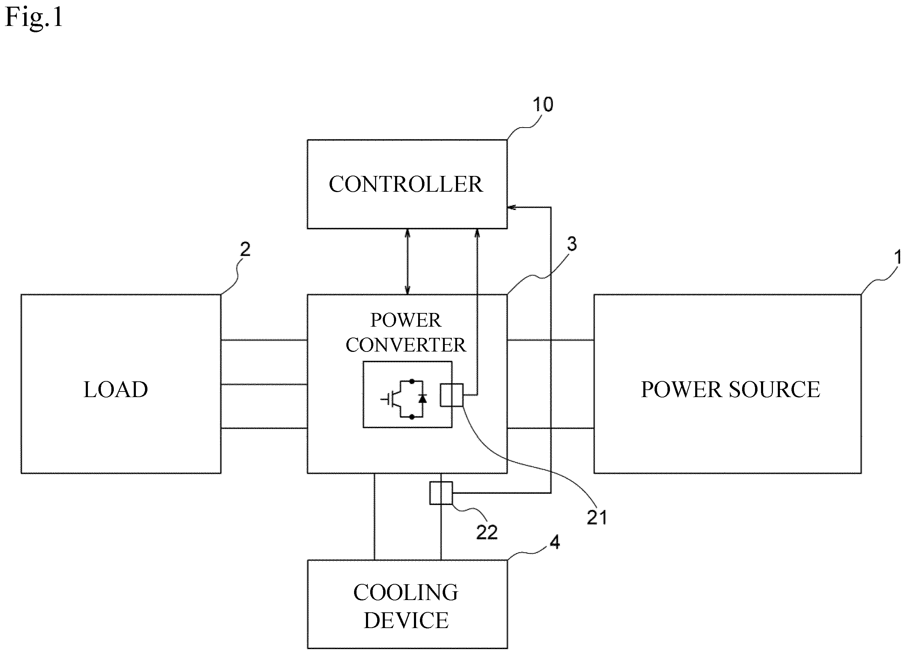

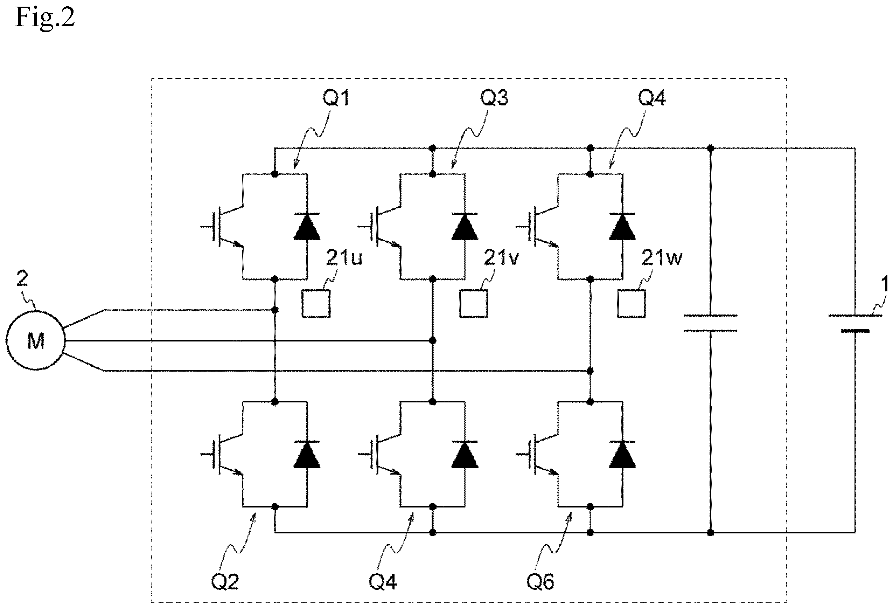

Fig. 1 is a block diagram of a drive system including an the device protection apparatus according to the present embodiment. Fig. 2 is a circuit diagram of the power supply 1, the load 2, and inverter circuit. The drive system includes a power supply 1, a load 2, a power converter 3, a cooling device 4, and a controller 10.

Power supply 1 is a power source of vehicle, and a battery group in which a secondary battery such as a lithium-ion battery is connected in parallel or in series. Load 2 is an motor (electric motor) and is coupled to the wheels to provide a rotational force to the wheels. For example, three-phase AC motor is used for the load 2.

Power converter 3 is connected between the power supply 1 and the load 2. The power converter 3 includes a inverter circuit and a control circuit. Inverter circuit is a circuit that enables two-phase three-phase conversion by connecting switching element such as IGBT in a bridge-like manner. The inverter circuit is connected between the load 2 and the power supply 1. The inverter circuit connects three phases of series circuit connected in series with several switching element in parallel. As shown in Fig. 2, in the inverter circuit, connection point between switching element (Q1, Q3, Q5) of the upper arm and switching element (Q2, Q4, Q6) of the lower arm are connected to output terminal of the UVW phase on the motor 2 side. The inverter circuit also has a smoothing capacitor C. The smoothing capacitor C smooths the input and output voltages of the power supply 1. The smoothing capacitor C is connected between the circuit of the bridge-shaped switching element and the connection terminal of the power supply 1 side.

Power converter 3 has a temperature sensor 21 for detecting the internal temperature of the device. The power converter 3 performs power conversion by switching on/off switching element included in inverter circuitry. When the switching element is turned on/off, heat is generated due to switching loss. The switching element is modularized as a power module and is provided inside the power converter 3.

Temperature sensor 21 is detecting the temperature of the power module rising by the switching operation of switching element. The temperature sensor 21 is installed in the power module. The temperature sensor 21 has a plurality of the device temperature sensors 21u, 21w, 21v. The device temperature sensor 21u detects the temperatures of the u-phase switching element (Q1, Q2). The device temperature sensor 21v detects the temperatures of switching element (Q3, Q4) of the v phase. The device temperature sensor 21w detects the temperatures of the w-phase switching element (Q5, Q6). The device temperature sensors 21u, 21v, and 21w is a thermistor inside the power module, or is constituted by on-chip temperature sensor or the like on the semiconductor chip in the power module. When the device temperature sensor 21u is configured with on-chip temperatures sensor, then the device temperature sensor 21u is installed on switching element Q1 and switching element Q2, respectively. The device temperature sensors 21u, 21v, and 21w, by synchronizing the detection period, detects the temperature of the three phases at the same timing. That is, a plurality of the device temperature sensors 21u, 21v, and 21w, while synchronizing the respective detection timing, in synchronized timing, and outputs a plurality of detected values to the controller 10. The detected value of the temperature sensor 21, via controller in the power converter 3 may be output to the controller 10.

The cooling device 4 cools the power converter 3 by circulating the refrigerant in the power converter 3. The cooling unit 4 includes a pump for outputting the refrigerant, a regulating valve for adjusting the refrigerant quantity, a cool exchanger, and the like. Between the cooling device 4 and the power converter 3 is connected by a flow path for passing the refrigerant. The flow passage leaves the cooling device 4, passes through the inside of the power converter, and is formed to return to the cooling device 4. The refrigerant is used to cool the power module and is a liquid such as water or the refrigerant gas.

The cooling device 4 has a temperature sensor (the refrigerant temperature sensor) 22 for detecting the temperature of the refrigerant. The temperature sensor 22 is provided in the flow path. The temperature sensor 22 outputs the detected value to the controller 10.

The controller 10 is a computer for executing the control process of the device protection apparatus, by controlling the power converter 3 based on the detected temperatures detected by the temperature sensor 21 and the temperature sensor 22, to protect the power converter 3. The controller 10 includes a ROM (Read Only Memory) in which a program for executing a control for protecting the power converter 3 is stored, a CPU (Central Processing Unit) for executing a program stored in the ROM, and a RAM (Random Access Memory) that functions as an accessible storage device. The controller 10 is connected to a controller in the power converter 3 by a signaling line. Incidentally, the controller 10 is provided in the power converter 3, and the controller 10 may have a function of controlling the switching operation. The controller 10 may also directly control switching element in the power module.

Next, a control flow for protecting the power converter 3 by controller 10 will be described with reference to Fig.2. The controller 10, during the driving of the power converter 3,executes the following control flow at a predetermined cycle.

In step S1, the controller 10 detects the temperature (T1) of the refrigerant using the temperature sensor 22. In step S2, the controller 10, using the device temperature sensors 21u, 21v, and 21w, detects the temperature of each phase of the power module of the power converter 3 (the device temperature :T2u, T2v, T2w).

In step S3, the controller 10 calculates the highest temperature (maximum device temperature :T2) among the detected temperatures detected by the device temperature sensors 21u, 21v, and 21w. In step S4, the controller 10 calculates the temperature difference (ΔT=T2-T1) by calculating the difference between the detected refrigerant temperatures (T1) and the calculated maximum device temperature (T2).

In step S5, the controller 10 compares the temperature difference with a predetermined temperature difference threshold value (ΔT_ₜₕ₁), and compares the maximum device temperature (T2) with the temperature threshold value (T ₜₕ₁). The temperature difference threshold value (ΔT_ₜₕ₁ the threshold value) is a predetermined threshold value. When the ambient temperature is low, as described below, the rate of temperature rise of the device is higher than the rate of temperature rise of the refrigerant and the temperature difference rises faster. The temperature difference threshold value (ΔT_ₜₕ₁) indicates a timing in the temperature difference for applying the drive limitation to the power converter 3 before the temperature of the power converter 3 reaches the allowable temperature in a state in which the temperature of the power converter 3 rises in a low-temperature state. Further, the temperature threshold value (T_ₜₕ₁) is an the threshold value for determining whether to execute the first protective process to be described later, it is set to a temperature higher than the temperature difference threshold value (ΔT_ₜₕ) The temperature difference threshold value (ΔT_ₜₕ₁) is the threshold value for low temperature environment and the temperature threshold value (T_ₜₕ₁) is the threshold value for high temperature environment.

When the temperature difference(ΔT) is higher than the temperature difference threshold value(ΔT_ₜₕ₁), or when the maximum device temperature(T2) is higher than the temperature threshold value(T_ₜₕ₁), the controller 10 performs the control flows of step S6. On the other hand, when the temperature difference(ΔT) is equal to or less than the temperature difference threshold value(ΔT_ₜₕ₁) and when the maximum device temperature(T2) is equal to or less than the temperature threshold value(T_ₜₕ₁), the controller 10 executes the control flow of step S8.

In step S6, the controller 10 determines whether or not the switching frequency can be limited based on the current driving condition of motor. The controller 10 checks the driving status of motor by obtaining the motor rotation speed from the power converter 3. The switching frequency is the carrier frequency when switching element is turned on/off. When the temperature difference (ΔT) is higher than the temperature difference threshold value (ΔT_ₜₕ), or when the the maximum device temperature (T2) is higher than the temperature threshold value (T1_{_th1}), the controller 10 applies the drive limitation to the power module to suppress the temperature rise of the power module. Applying the drive limitation to the power module also limits motor drive. The drive limitation is performed by making the carrier frequency lower than the present frequency. However, when the switching frequency is set low while motor speed is high, control divergence may occur. Therefore, in the control flow of step S6, it is determined whether or not the driving state of motor is in a state in which the switching frequency can be set low. Specifically, the controller 10 compares the current the motor rotation speed with the rotation speed threshold value to determine that the switching frequency can be limited when the present motor rotation speed (N) is lower than the rotational speed threshold value (Nₜₕ). The controller 10 determines that the switching frequency can not be limited when the present motor rotation speed is the rotational speed threshold value or more. The rotational speed threshold value is predetermined and may be set to a value corresponding to the torque of motor.

When determining that the switching frequency can be limited, the controller 10 performs a first protecting process in step S7. The first protective process applies the drive limitation to the motor 2 by limiting the switching frequency. Specifically, the controller 10 obtains the output torque and the current motor rotation speed of the motor from the power converter 3. The selectable switching frequency is predetermined, and the selectable switching frequency differs depending on the driving status of motor.

For example, as a selectable switching frequency, three frequencies (f_{sw1}, f_{sw2}, f _{sw3}) are preset. However, the frequency (f_{sw3}) is highest and the frequency (f_{sw1}) is lowest. Further, the rotational speed threshold value (N_{th_L}) which is lower than the rotational speed threshold value is preset. Then, the selectable switching frequency is determined in accordance with the present rotational speed of motor. When the present rotational speed N of motor is higher than the rotational speed threshold value (Nₜₕ), the selectable switching frequency is only f_{sw3}, which corresponds to a condition in which the switching frequency cannot be limited. When the current rotation speed of motor is less than or equal to the rotation speed threshold value (Nₜₕ) and high than the rotation speed threshold value (N_{th_L}), the selectable switching frequencies are the frequency (f_{sw3}) and frequency (f_{sw2}). Then, for example, when the present carrier frequency is higher than the frequency (f_{sw2}) and lower than the frequency (f_{sw3}), the controller 10 sets the carrier frequency to the frequency (f_{sw2}) and limits the carrier frequency. Also, when the present rotational speed of motor is less than or equal to the rotational speed threshold value (N_{th_L}), the selectable switching frequency is the frequency (f_{sw1}), the frequency (f_{sw2}), and the frequency (f_{sw3}). For example, when the present carrier frequency is higher than the frequency (f_{sw3}), the controller 10 sets the carrier frequency to the frequency (f_{sw3}) and limits the carrier frequency. That is, the controller 10, when there are a plurality of selectable switching frequencies according to the present rotational speed of motor, set to a carrier frequency lower than the present carrier frequency. Thus, loss is suppressed, it is possible to suppress the heat generation of the power module. The selectable switching frequency is not limited to the motor rotation speed, it may be determined by the torque of motor.

In step S8, the controller 10 compares the temperature difference with a predetermined temperature difference threshold value (ΔT_{_th2}), and compares the device temperature (T2) with the temperature threshold value (T_{_th1}). The temperature difference threshold value (ΔT_ₜₕ₂) is a threshold value for determining whether to execute the second protective process to be described later, it is set to a temperature higher than the temperature difference threshold value (ΔT_ₜₕ₁) The temperature threshold value (T_ₜₕ₂) is a threshold value for determining whether to execute the second protective process to be described later, is set to a temperature higher than the temperature threshold value (T_ₜₕ₁).

When the temperature difference(ΔT) is higher than the temperature difference threshold value(ΔT_ₜₕ₂), or when the maximum device temperature(T2) is higher than the temperature threshold value(T_{_th2}), the controller 10 performs the control flows of step S6. On the other hand, when the temperature difference(ΔT) is equal to or less than the temperature difference threshold value(ΔT_ₜₕ₂) and when the maximum device temperature(T2) is equal to or less than the temperature threshold value(T_{_th2}), the controller 10 executes the control flow of step S10.

In step S9, the controller 10 executes the second protecting process. When the controller 10 determines that the control flow of step S8 is "Yes" since the maximum device temperature (T2) is equal to or less than the temperature threshold value (T_{_th2}), the controller 10 executes the second protecting process in which the output torque from motor is limited by setting the required torque when the maximum device temperature (T2) reaches to the temperature threshold value (T_ₜₕ₂) to the maximum output from motor. When the controller 10 determines that the control flow of step S8 is "Yes" since the temperature difference (ΔT) is equal to or less than the temperature difference threshold value (ΔT_{_th2}), the controller 10 executes the second protecting process in which the output torque from motor is limited by setting the required torque when the temperature difference (ΔT) reaches to the temperature difference threshold value (ΔT _ₜₕ₂) to the maximum output from motor.

Specifically, when the maximum device temperature (T2) reaches the temperature threshold value (T_ₜₕ₂), the controller 10 transmits a command to controller of the power converter 3 so as to set the upper limit of torque command value corresponding to the required torque to the current torque command value. The controller of the power converter 3, when receiving the command signal, sets the present torque command to the upper limit. Even if a required torque exceeding the upper limit of the torque command is entered by the driver's accelerator after the upper limit is set, the controller controls switching element by limiting torque command value to the upper limit and generating a switching signal corresponding to the present rotational speed of motor and the present current of motor. Thus, since the limit is applied to the required torque, the output torque of motor is suppressed, as a result, the temperature of the power module is suppressed.

In step S10, the controller 10 compares the temperature difference (ΔT) with an upper limited temperature difference threshold value (ΔT_ₜₕ₃) predetermined and compares the device temperature (T2) with the upper limited temperature (T_ₜₕ₃). The upper limited temperature difference threshold value (ΔT_ₜₕ₃) indicates the upper limit of the temperature allowed for the power module and is set to a higher temperature than the temperature difference threshold value (ΔT_{_th1}) and the temperature difference threshold value (ΔT_{_th2}). The upper limited temperature (T_{_th3}) indicates the upper limit of the temperature allowed for the power module and is set to a temperature higher than the temperature threshold value (T_{_th1}) and the temperature threshold value (T_{_th2}).

When the temperature difference (ΔT) is higher than the upper limited temperature difference threshold value (ΔT_{_th3}), or when the maximum device temperature (T2) is higher than the upper limited temperature threshold value (T_{_th3}), the controller 10 executes the control flow of step S11. On the other hand, when the temperature difference (ΔT) is equal to or less than the upper limited temperature difference threshold value (ΔT_{_th3}) and when the maximum device temperature (T2) is equal to or less than the upper limited temperature threshold value (T_{_th3}), the controller 10 terminates the control flowchart.

In step S11, the controller 10 transmits a fail-safe signal indicating that motor is forcibly stopped to controller in the power converter 3. The controller in the power converter 3 stops the operation of the power converter 3 when receiving a fail-safe signal (fail-safe process). Thus, the power module can be prevented from exceeding the upper limit value.

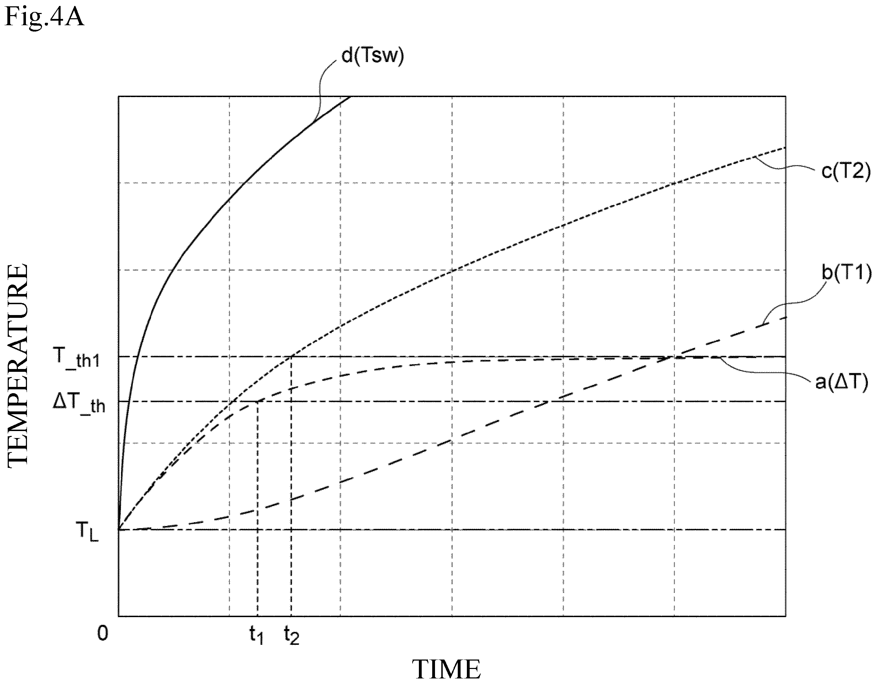

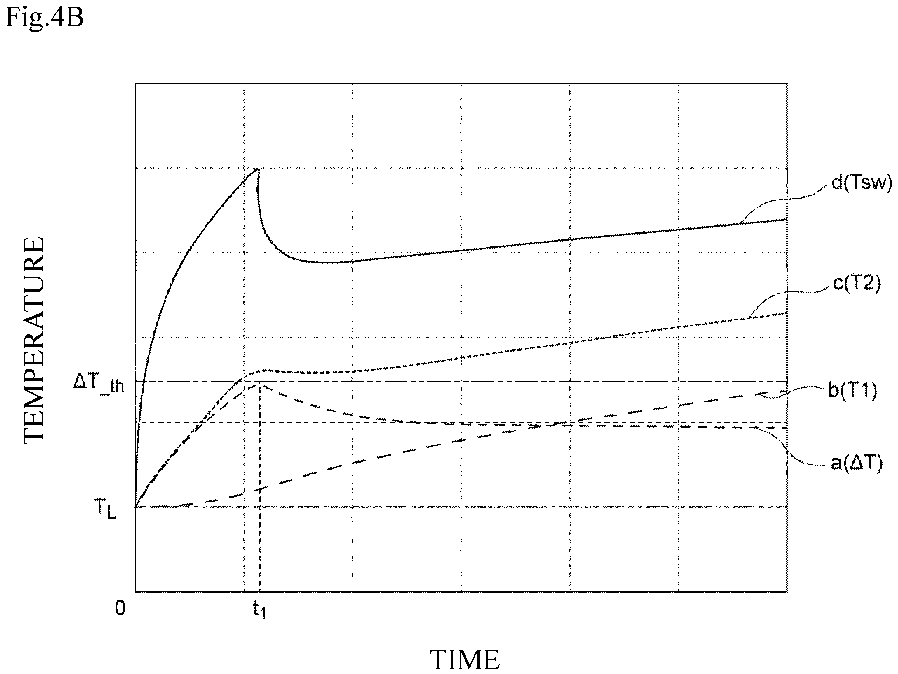

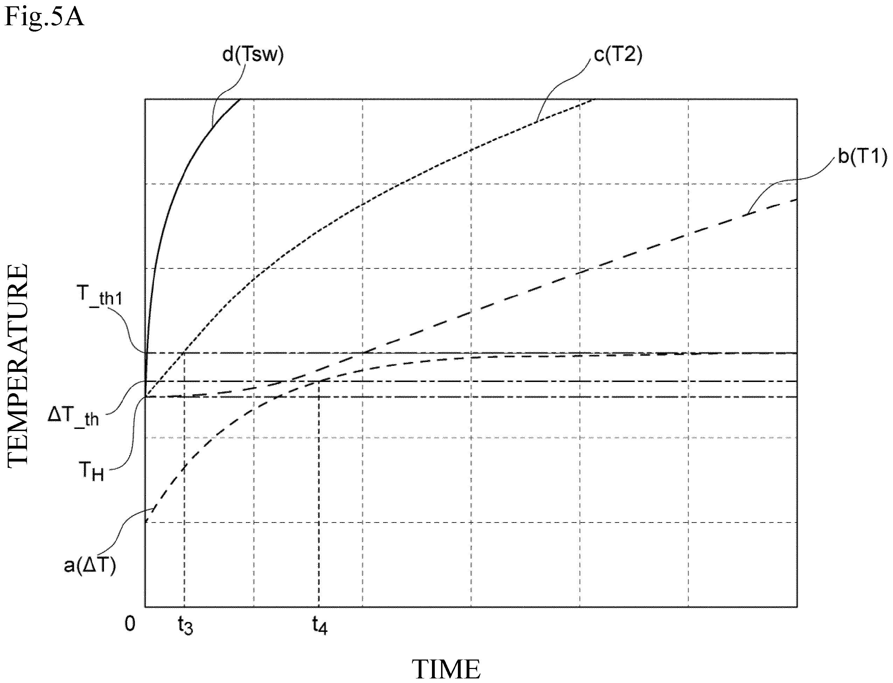

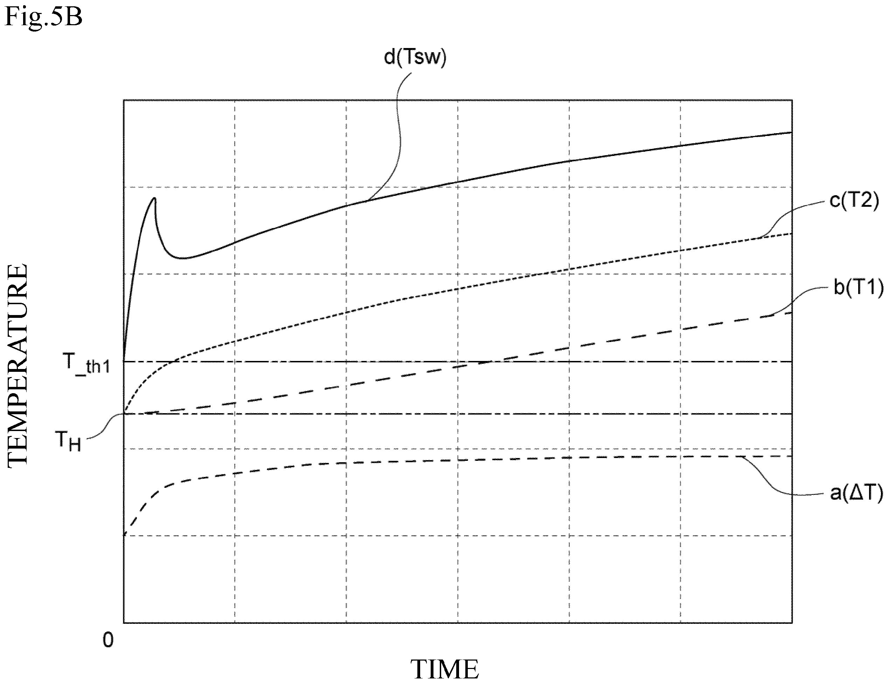

Next, the relationship between the first protective process and the temperature will be described with reference to Fig. 4A, Fig. 4B, Fig. 5A, and Fig. 5B. Fig. 4A and Fig.4B shows the temperature characteristics when the environmental temperature is low temperature (T_{L}), Fig. 5A and Fig. 5B shows the temperature characteristics when the environmental temperature is high temperature (T_{H}). In the Fig. 4A, Fig. 4B, Fig. 5A, in Fig. 5B, the graph a shows the properties of the temperature difference (ΔT), the graph b shows the refrigerant temperature (T1) detected by the temperature sensor 22, the graph c shows the maximum device temperature of detected temperature (T2) detected by the temperature sensor 21, the graph d shows the actual temperature of switching element (Tsw). The horizontal axis indicates time, and the vertical axis indicates the magnitude of temperature. Fig. 4A and Fig. 5A show the properties (comparative examples) when the device protection apparatus according to this embodiment is not provided in the drive system. Fig. 4B and Fig. 5B show the properties in a case in which the device protection apparatus according to the present embodiment is provided in the drive system.

As shown in Fig. 4A, when the ambient temperature is low, the maximum device temperature (T2) reaches the temperature threshold value (T_{_th1}) at time t2. On the other hand, the temperature difference (ΔT) reaches the temperature difference threshold value (ΔT_{_th}) at time t1 earlier than time t2. That is, at low temperatures, the temperature difference between the refrigerant temperature and the device temperature widens and the temperature difference(ΔT) reaches the temperature difference threshold value(ΔT_{_th}) before the maximum device temperature(T2) reaches the temperature threshold value(T_{_th1}). Then, as shown in Fig. 4B, in the present embodiment, when the temperature difference (ΔT) reaches the temperature difference threshold value (ΔT_{_th}), since the first protective process is executed, the temperature of switching element is reduced prior to become a high temperature, switching element temperature (Tsw) can be suppressed. On the other hand, in the comparative example that does not execute the first protective process, even after the time t1, switching element temperature (Tsw) continues to rise.

As shown in 5A, when the ambient temperature is high, the maximum device temperature (T2) reaches the temperature threshold value (T_{_th1}) before the temperature difference (ΔT) reaches the temperature difference threshold value (ΔT_{_th}) (Time:t3). Then, as shown in Fig. 5B, in the present embodiment, when the temperature difference (T2) reaches the temperature threshold value (T_{_th1}), since the first protective process is executed, the temperature of switching element is reduced prior to becoming a high temperature, switching element temperature (Tsw) can be suppressed.

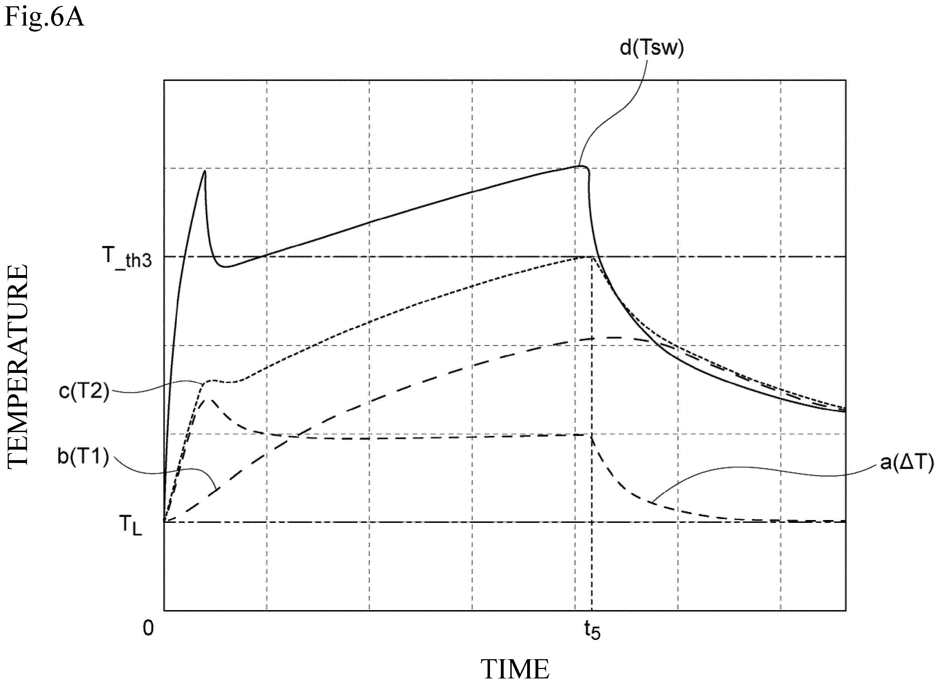

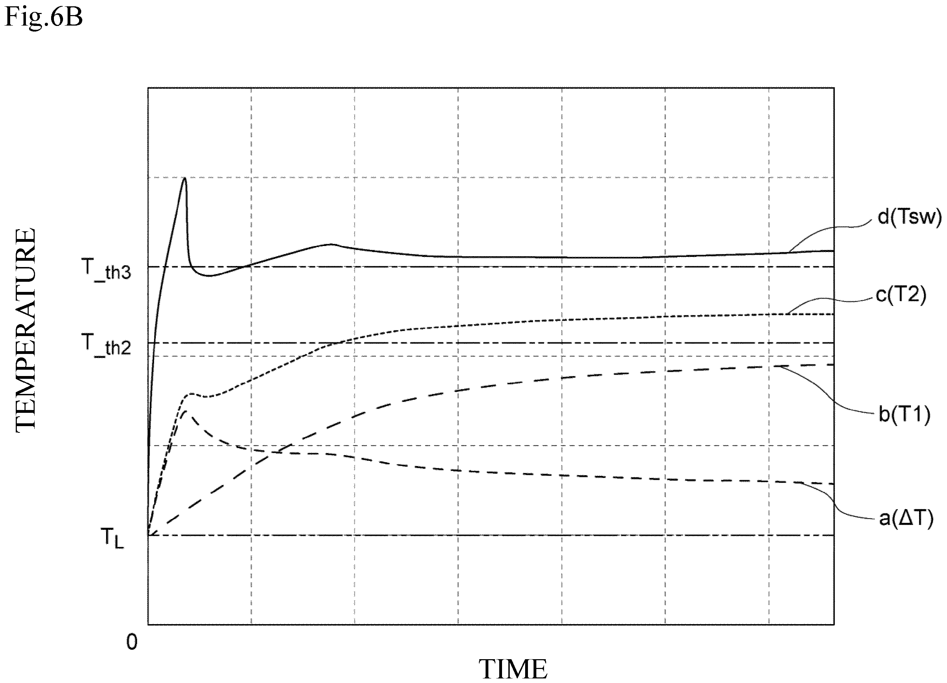

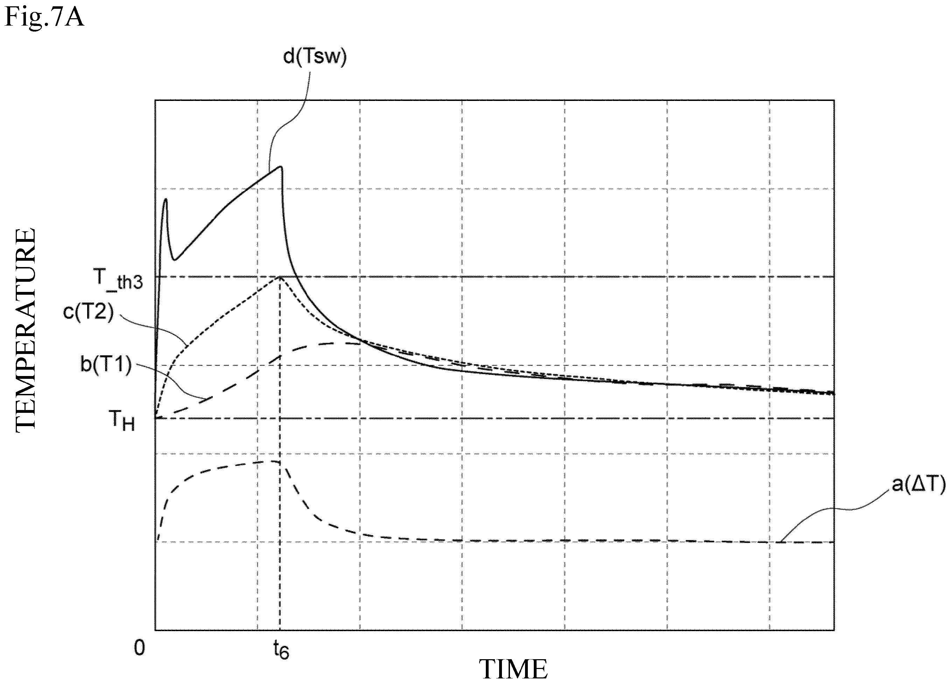

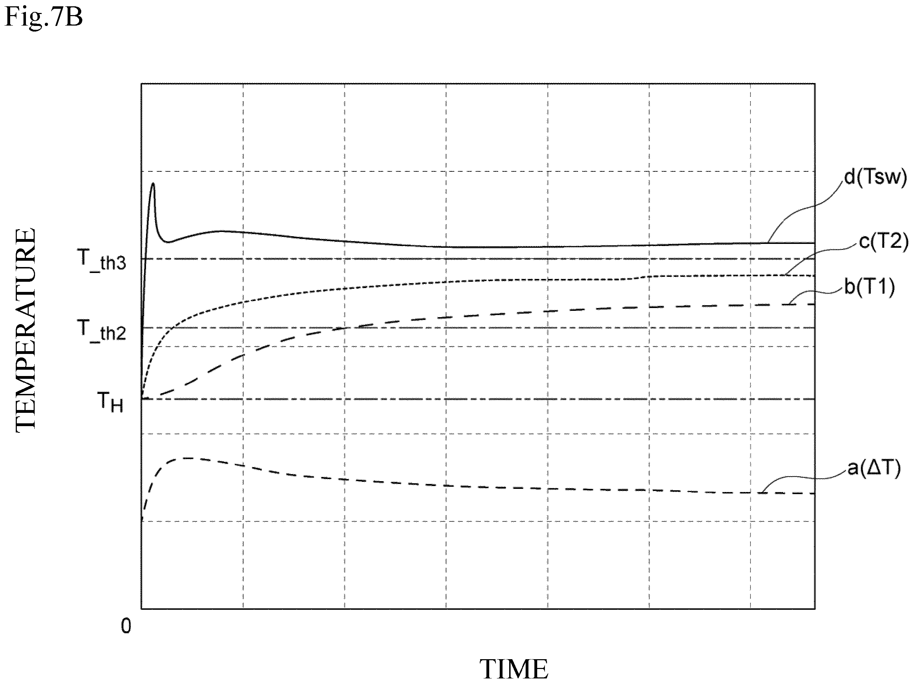

Next, the relationship between the second protective process and the temperature will be described with reference to Fig.6A, Fig.6B, Fig.7A, and Fig.7B. Fig.6A and Fig.6B show the temperature characteristics when the environmental temperature is low temperature (T_{L}), Fig.7A and Fig.7B shows the temperature characteristics when the environmental temperature is high temperature (T_{H}). In the Fig.6A , Fig.6B, Fig.7A, and Fig.7B, the graph a shows the properties of the temperature difference (ΔT), the graph b shows the refrigerant temperature detected by the temperature sensor 22 (T1), the graph c shows the maximum device temperature of detected temperature detected by the temperature sensor 21 (T2), the graph d shows the actual temperature of switching element (Tsw). The horizontal axis indicates time, and the vertical axis indicates the magnitude of temperature. Fig. 6A and Fig. 7A show the properties when the device protection apparatus according to the present embodiment performs only the first protection process, and Fig. 6B and Fig. 7B show the characteristics when the device protection apparatus according to the present embodiment performs the first protection process and the second protection process.

As shown in Fig. 6A, when the temperature of the power module continues to rise after the first protection process, the fail-safe process is executed because the maximum device temperature (T2) reaches the upper limit temperature (T_{_th3}) at the time (t₅). On the other hand, in the present embodiment, as shown in Fig. 6B, prior to the maximum device temperature (T2) reaches the upper limit temperature (T_{_th3}), when the maximum device temperature (T2) reaches the temperature threshold value (T_{_th2}), the second protective process is executed, the output at the time that the maximum device temperature (T2) reaches the temperature threshold value (T_{_th2}) is an upper limit, the torque limit is applied. Thus, it is possible to suppress the temperature rise of switching element and extend the operation time of the power converter 3.

As shown in Fig. 7A, when the temperature of the power module continues to increase after the first protection process, the fail-safe process is executed because the maximum device temperature (T2) reaches the upper limit temperature (T_{_th3}) at the time (t₆). On the other hand, in the present embodiment, as shown in Fig. 7B, prior to the device temperature (T2) reaches the upper limit temperature (T_{_th3}), when the maximum device temperature (T2) reaches the temperature threshold value (T_{_th2}), the second protective process is executed, the output at the time the maximum device temperature (T2) reaches the temperature threshold value (T_{_th2}) is an upper limit, the torque limit is applied. Thus, even at a high temperature of the environmental temperature, to suppress the temperature rise of switching element, it is possible to extend the operation time of the power converter 3.

In the present embodiment, in order to determine whether to execute the protective process, the highest temperature among detected temperatures detected by a plurality of the device temperature sensors 21u, 21v, and 21w is compared object. For example, when motor rotates at a low speed, the temperature difference of each phase increases. For example, when only a particular part of the modularized switching element (Q1-Q6) is detected using one sensor, the temperature of one phase is reflected in detected temperature and the temperature of the other phase is less likely to be reflected in detected temperature. Then, when motor rotation speed is low, the temperature of the other phases may be higher than the phase detected by the temperature sensor. In the present embodiment, a plurality of the device temperature sensors 21u, 21v, and 21w detects the device temperature for each phase, a protective process is executed based on the maximum temperature. Thus, for example, while considering the temperature difference in each phase occurring at motor low rotational speed, it is possible to perform the thermal protection of the heat generation the device.

The device protection apparatus according to the present embodiment as described above, among the temperatures detected by a plurality of the device temperature sensor 21u, 21v and 21w, specifies the highest detected temperature as the detected device temperature, calculates the temperature difference between the detected refrigerant temperature and the detected device temperature, applies the drive limitation to the device when the temperature difference is higher than the predetermined temperature difference threshold value, and applies the drive limitation to the device when the detected device temperature is higher than the predetermined temperature threshold value. Thus, even in a state in which the temperature variation occurs, it is possible to suppress the deterioration of the protective function. Further, it is possible to suppress the temperature rise of the heating portion, it is possible to suppress the heat load applied to the heat-generation part or the device. In addition, the operating hours of the device can be extended.

In the present embodiment, when the detected device temperature (T2) is higher than the first temperature threshold value, the first protective action (first protective process) applies the drive limitation to the device. The second protective action applies the drive limitation to the device when the detected device temperature is higher than the second protective action after applying the drive limitation to the device in the first protective action. This limits the power that is directly responsible for raising the heat-generation part's temperature and expands the device's operable time. Note that the first temperature threshold value corresponds to the temperature threshold value (T_ₜₕ₁) or the temperature threshold value (T_{_th2}), the second temperature threshold value corresponds to the temperature threshold value (T_{_th2}) or the temperature threshold value (T_{_th3}), the first protective action corresponds to the first protection process or the second protection process, the second protective action corresponds to the second protection process or the third protection process.

In the present embodiment, when the temperature difference (ΔT) is higher than the first temperature difference threshold value, the first protective action applies the drive limitation to the device, and the second protective action applies the drive limitation to the device when the temperature difference is higher than the drive limitation after applying the drive limitation to the device in the first protective action. This limits the power that is directly responsible for raising the heat-generation part's temperature and expands the device's operable time. Incidentally, the first temperature difference threshold value corresponds to the temperature difference threshold value (ΔT_{_th1}) or the temperature difference threshold value (ΔT_{_th2}), the second temperature difference threshold value corresponds to the temperature difference threshold value (ΔT_{_th2}) or the temperature difference threshold value (ΔT_{_th3}), the first protective action corresponds to the first protection process or the second protection process, the second protective action corresponds to the second protection process or the third protection process.

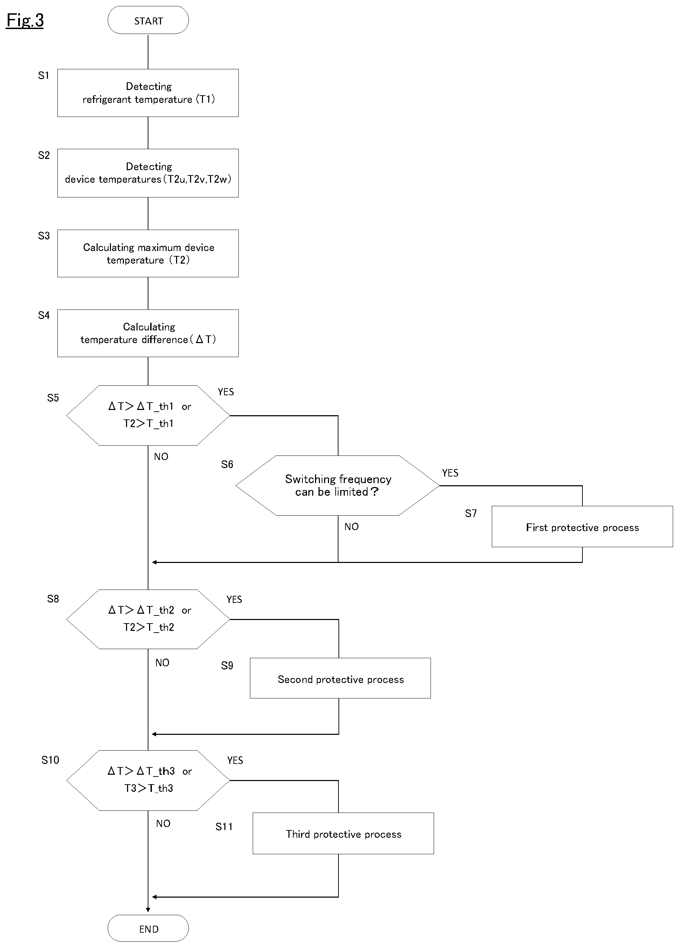

In the present embodiment, in order to determine whether to apply the drive limitation to motor 2, but using the maximum device temperature, it may not necessarily be the maximum device temperature. For example, the controller 10, among detected temperature detected by the device temperature sensors 21u, 21v, and 21w, specifies a detected temperature higher than the lowest detected temperature as the detected device temperature to be compared, and may be the drive limitation for motor 2 based on the detected device temperature identified. The control flow of the controller 10 at this time is the same as the control flow shown in Fig 3.

### «Second Embodiment»

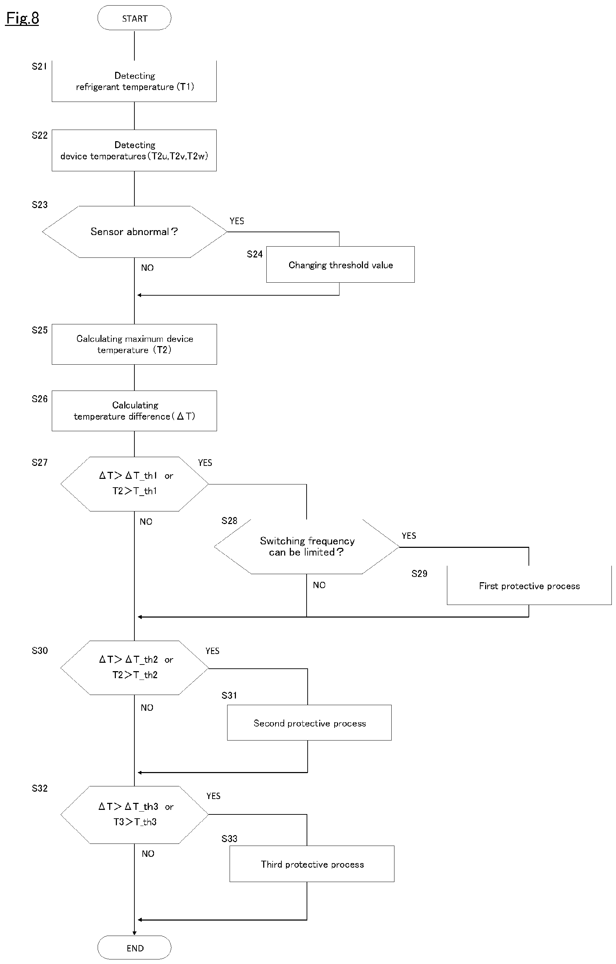

Fig. 8 is a flow chart illustrating a control flow of controller of the device protection apparatus according to another embodiment of the present invention. In the present embodiment, with respect to the first embodiment described above, a part of the control flow is different. Other configurations are the same as those of the first embodiment described above, and the above description is incorporated by reference for the configuration of the device protection apparatus and the control flowchart of controller.

The control flowchart of controller 10 will be described with reference to Fig.8. The control flows of step S21 and S22 are the same as the control flows of step S1 and S2 described in the first embodiment, and therefore descriptions thereof are omitted.

In step S23, the controller 10 determines that whether or not an abnormality has occurred in the device temperature sensor 21u, 21v, and 21w, based on detected temperature detected by 21w, 21v, and 21w (T2u, T2v, T2w). Specifically, the controller 10 determines whether or not the detected temperature of the device temperature sensor 21u is within a predetermined normal range. The controller 10 determines that the device temperature sensor 21u is normal when the detected temperature is within the normal range, and determines that the device temperature sensor 21u is abnormal when the detected temperature is outside the normal range. The normal range is a pre-set range. The lower limit of the normal range is set in advance, for example, assuming a failure cause such as the detected value of sensor is attached at the lower limit value. The upper limit of the normal range is set in advance, for example, assuming a failure cause such as the detected value of sensor is attached at the upper limit value. The controller 10, not only the U-phase, also for the V-phase and W-phase, similarly, determines whether or not an abnormality has occurred in the device temperature sensor 21u and 21v.When it is determined that all the device temperature sensor 21u, 21v, and 21w are normal, the controller 10 executes the control flow of step S25. When it is determined that at least one sensor of the device temperature sensor 21 u, 21v, and 21w is abnormal, the controller 10 executes the control flow of step S24.

In step S24, the controller 10 changes the temperature threshold value (T_{_th1}, T_{_th2}, T_{_th3}) from the initial set value (T_{_th1_1}, T_{_th2_1}, T_{_th3_1}) to the set value (T_{_th1_2}, T_{_th2_2}, T_{_}t_{h3_2}). The set value (T_{_th1_2}, T_{_th2_2}, T_{_th3_2}) is a value lower than the initial set value (T_{_th1_1}, T_{_th2_1}, T_{_th3_1}). Further, the controller 10 changes the temperature threshold value (T_{_th1}, T_{_th2}, T_{_th3}) to the set value (T_{_th1_3}, T_{_th2_3}, T_{_th3_3}) when two of three the device temperature sensor 21u, 21v, and 21w are abnormal. The set value (T_{_th1_3}, T_{_th2_3}, T_{_th3_3}) is a value lower than the set value (T_{_th1_2}, T_{_th2_2}, T_{_th3_2}).

In step S25, the controller 10 calculates the highest temperature (maximum device temperature :T2) of detected temperature detected by the device temperature sensor 21u, 21v, and 21w. When an abnormality occurs in at least one of the device temperature sensor 21u, 21v, and 21w, the controller 10 excludes the detected value of sensor in which the abnormality has occurred and calculates the maximum device temperature (T2) from among detected temperature detected by the device temperature sensor 21u, 21v, and 21w in which the abnormality has not occurred. For example, when there is an abnormality in the device temperature sensor 21u of the u-phase, the controller 10 calculates the maximum device temperature (T2) among the detected temperatures of the device temperature sensor 21v of the v-phase and w-phase. This allows sensor of other phases to be used to continuously protect the device even if one phase of the detector fails.

Since the control flow of step S26 to S33 is the same as the control flow of step S4 to S11 shown in the first embodiment, the explanation thereof is omitted. However, in the control flow of step S24, when the temperature threshold value (T_{_th1}, T_{_th2}, T_{_th3}) is changed, the controller 10 compares the changed temperature threshold value with the maximum device temperature (T2) and executes the first to third protection processes according to the comparison result.

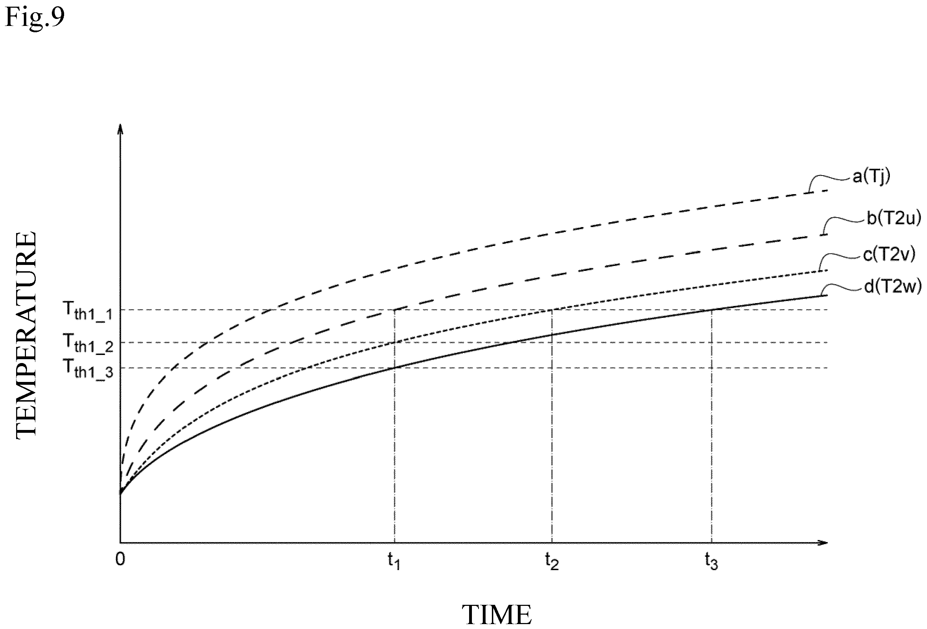

Next, with reference to Fig.9, the relationship between a temperature change when an abnormality occurs in sensor 21u, 21v, and 21w and the temperature threshold value (T_{_th1_1}, T_{_th1_2}, T_{_th1_3}) will be described. For example, when the u-phase of motor 2 is locked, the temperature at which the maximum of the power module (Tj) is changed as in the graph a of Fig. 9. At this time, when position of the power module to be the maximum temperature is in the vicinity of switching elements of the u-phase (Q1, Q2), detected temperature of the device temperature sensor 21u rises faster than the detected temperature of the device temperature sensor 21v and 21w of v, w-phase. Therefore, if the device temperature sensor 21u is normal, when the detected temperature (T2u) of the device temperature sensor 21u reaches the temperature threshold value (T_{_th1_1}) (time t₁), the first protective process is executed. On the other hand, when there is an abnormality in the device temperature sensor 21u, since the detected value of the device temperature sensor 21u does not show a normal value, the maximum device temperature (T2) is detected temperature of the v-phase. Then, when detected temperature (T2v) of the device temperature sensor 21v reaches the temperature threshold value (T_{_th1_1}) (time t₂), the first protective process is executed. Furthermore, if there is an abnormality in the device temperature sensor 21u and the device temperature sensor 21v, the maximum device temperature (T2) becomes detected temperature of the w-phase, when the detection temperature (T2w) of the device temperature sensor 21w reaches the temperature threshold value (T_{_th1_1}) (time t₃), the first protective process is executed.

That is, if the device temperature sensor 21u, 21v, or 21w is abnormal, and the temperature threshold value is set to the initial set value(T_{_th1_1}) and the device protective process is executed, there is a possibility that timing for applying the drive limitation is delayed. In this embodiment, when there is an abnormal in the device temperature sensor 21u, 21v, and 21w, the temperature threshold value (T_{_th1}, T_{_th2}, T_{_th3}) is low, it is possible to protect motor 2.

As described above, in the present embodiment, whether or not an abnormality occurs in the device temperature sensor 21u, 21v, and 21w is determined on the basis of the temperature detected by the device temperature sensor 21u, 21v, and 21w, when it is determined that an abnormality has occurred in at least one of a plurality of the device temperature sensor 21u, 21v, and 21w, the detected device temperature (T2) is identified from detection temperature detected by the device temperature sensor 21u, 21v, and 21w where the abnormality does not occur. Thus, when there is an abnormal in the device temperature sensor of a phase, by using sensors of other phase, it is possible to protect the device

In the present embodiment, when it is determined that an abnormality has occurred in at least one sensor of a plurality of the device temperature sensor 21u, 21v, and 21w, the temperature threshold value (T_{_th1}, T_{_th2}, T_{_th3}) is lower than the initial set value (T_{_th1_1}, T_{_th2_1}, T_{_th3_1}). This ensures that the device is properly protected when an abnormality has occurred in a sensor. Also, it is possible to extend the protectable temperature range.

In the modification of the present embodiment, when it is determined that at least one of sensor among the plurality of the device temperature sensor 21u, 21v, and 21w is abnormal, the temperature difference threshold value (ΔT_{_th1}, ΔT_{_th2}, and ΔT_{_th3}) may be lower than the initial set value. This ensures that the device is properly protected when an abnormality has occurred in a sensor as with change of the temperature threshold value (T_{_th1}, T_{_th2}, T_{_th3}).

In a modification of the present embodiment, when it is determined that an abnormality has occurred in at least one sensor of a plurality of the device temperature sensor 21u, 21v, and 21w, the detected value of the device temperature sensors 21u, 21v, and 21w where the abnormality has not occurred may be higher than the normal detected value (detected value during normal). This ensures that the temperature threshold value (T_{_th1}, T_{_th2}, T_{_th3}) is properly protected from the device even when sensor becomes abnormal.

### «Third Embodiment»

The device protection apparatus and the device protective methods according to another embodiment of the present invention will be described. In the present embodiment, the control flow of step S24 differs from the control flow of the second embodiment described above. Control of other configurations and the controller 10 is the same as the second embodiment described above, and the above description is incorporated by reference for control of other configurations and controller 10.

When it is determined that at least one sensor of the device temperature sensor 21 u, 21v, and 21w is abnormal, the controller 10 performs the following control in the control flow of step S24. The controller 10 calculates the temperature difference (ΔTp) between the device temperature sensor 21u, 21v, 21w in which the abnormality has not occurred and the device temperature sensor 21u, 21v, 21w in which the abnormality has occurred. The greater the calculated temperature difference (ΔTp), the controller 10 sets the temperature threshold value (T_{_th1}, T_{_th2}, T_{_th3}) to a lower temperature. Then, the controller 10, using the set temperature threshold value (T_{_th1}, T_{_th2}, T_{_th3}), executes the control flow after step S25.

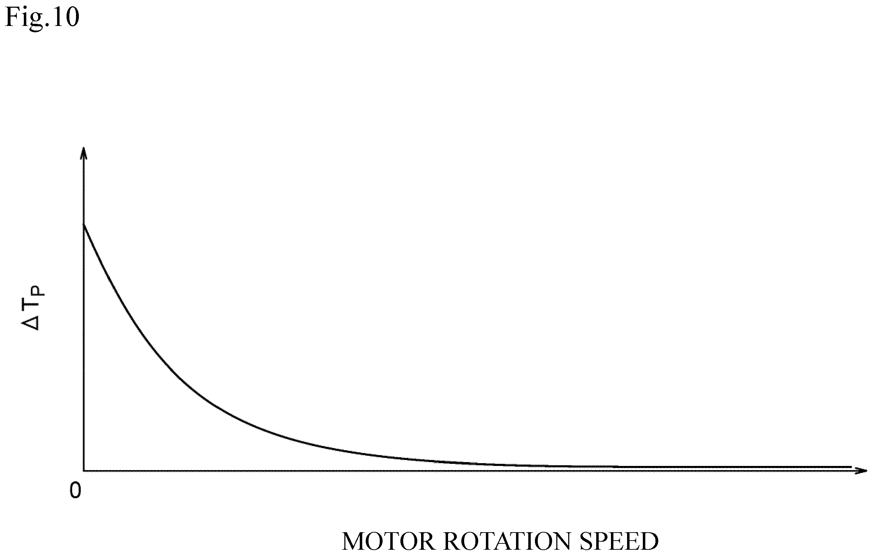

Fig. 10 is a graph showing the relationship between the motor rotation speed and the temperature difference (ΔTp). As shown in Fig.10, there is a relationship between the temperature difference (ΔTp) and the motor rotation speed, and the lower the motor rotation speed, the higher the temperature difference (ΔTp). The higher the temperature difference (ΔTp), the greater the difference between the detected values of normal the device temperature sensor 21u, 21v, 21w and the temperature of the hottest part of the module may be. Therefore, in this embodiment, the larger the temperature difference (ΔTp), by setting the temperature threshold value (T_{_th1}, T_{_th2}, T_{_th3}) to a lower value, when the temperature of the module is raised, the drive limitation is applied at a faster timing.

On the other hand, when the temperature difference (ΔTp) is low, the difference between the detected values of the normal device temperature sensor 21u, 21v, and 21w and the temperature of the part where the temperature is highest among the modules is small. Therefore, in the present embodiment, the smaller the temperature difference (ΔTp), the closer the temperature threshold value (T_{_th1}, T_{_th2}, T_{_th3}) to the value of the initial value, thereby expanding the protective unnecessary area.

In this embodiment as described above, in accordance with the temperature difference between detected temperature of the device temperature sensor where the abnormality has occurred and detected temperature of the device temperature sensor where the abnormality has not occurred, the temperature threshold value (T_{_th1}, T_{_th2}, T_{_th3}) is set. Thus, the area to be restricted and the area to be not restricted can be appropriately set for the operation area of the device. Incidentally, the controller 10 may set the temperature difference threshold value (ΔT_{_th1}, ΔT_{_th2}, ΔT_{_th3}) to lower values and may set the temperature threshold value (T_{_th1}, T_{_th2}, T_{_th3}) and the temperature difference threshold value (ΔT_{_th1}, ΔT_{_th2}, ΔT_{_th3}) to lower values, as the temperature difference (ΔTp) is higher.

In a modification of the present embodiment, the controller 10 set he temperature threshold value (T_{_th1}, T_{_th2}, T_{_th3}) to a lower value as the lower the motor rotation speed. The motor rotation speed may be detected by the speed sensor of the resolver, etc. As shown in Fig. 10, the lower the motor rotation speed, the larger the temperature difference (ΔTp). Therefore, in the modification, the lower the motor rotation speed, the lower the temperature threshold value (T_{_th1}, T_{_th2}, T_{_th3}), the faster the drive limitation is applied at timing when the temperature of the module becomes higher. Thus, in the modification, when it is determined that an abnormality has occurred in at least one sensor of a plurality of the device temperature sensor 21u, 21v, and 21w, in response to the motor rotation speed, the temperature threshold value is set. Thus, the area to be restricted and the area to be not restricted can be appropriately set for the operation area of the device. Incidentally, the controller 10 may set the temperature difference threshold value (ΔT_{_th1}, ΔT_{_th2}, ΔT_{_th3}), the temperature threshold value (T_{_th1}, T_{_th2}, T_{_th3}), and the temperature difference threshold value (ΔT_{_th1}, ΔT_{_th2}, ΔT_{_th3}) to a lower values as the rotational speed lows.

In a modification of the present embodiment, the controller 10, depending on the motor angle, may be set the temperature threshold value (T_{_th1}, T_{_th2}, T_{_th3}). The motor angle may be detected by the speed sensor of the resolver, etc.

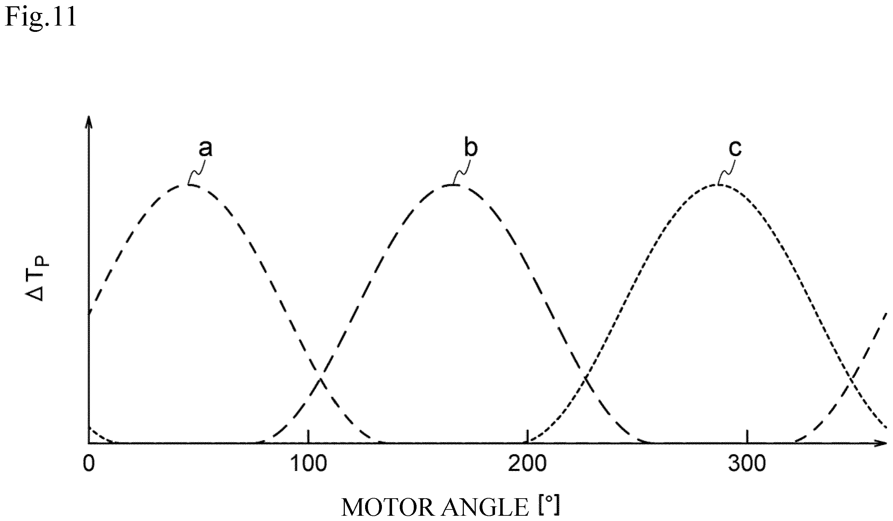

Fig. 11 is a graph showing the relationship between the motor angle and the temperature difference (ΔTp). Graph a shows the temperature difference (ΔTp) between the detected temperature of the device temperature sensor 21u of the u-phase and the detected temperature of the device temperature sensor 21u and 21v of the u,v-phase, when the abnormality has occurred in the device temperature sensor 21u of the u-phase. Graph b, when an abnormality occurs in the device temperature sensor 21v of the v-phase, shows the temperature difference (ΔTp) between the detected temperature of the device temperature sensor 21v of the v-phase and the detected temperature of the device temperature sensor 21u and 21w of the u,w-phase. Graph c, when an abnormality occurs in the device temperature sensor 21w of the w-phase, shows the temperature difference (ΔTp) between the detected temperature of the device temperature sensor 21w of the w-phase and the detected temperature of the device temperature sensor 21u and 21v of the u,v-phase.

For example, when an abnormality occurs in the device temperature sensor 21u of the u-phase, when the motor angle is from 0 to about 90 degrees, the temperature difference (ΔTp) is increased. On the other hand, when the motor angle is about 90 to 360 degrees, the temperature difference (ΔTp) decreases. For other phases (v, w), when the motor angle is within a specified range, the temperature difference (ΔTp) becomes larger, but when the motor angle is outside the specified range, the temperature difference (ΔTp) becomes lower. That is, there is a correlation between the temperature difference (ΔTp) and the motor angle.

The controller 10 identifies sensor of the phase in which the abnormality is occurring among the device temperature sensor 21u, 21v, and 21w. The controller 10 sets a motor angle region for each phase such that the temperature difference (ΔTp) becomes large. Then, the controller 10, when the detected motor angle is within the angular area, sets the temperature threshold value (T_{_th1}, T_{_th2}, T_{_th3}) to a value lower than the initial value. When the detected motor angle is outside the angular area, the controller 10 initializes the temperature threshold value (T_{_th1}, T_{_th2}, T_{_th3}). Thus, the area to be restricted and the area to be not restricted can be appropriately set for the operation area of the device. Incidentally, the controller 10 may set the temperature difference threshold value (ΔT_{_th1}, ΔT_{_th2}, ΔT_{_th3}) to a value smaller than the initial value, and may set the temperature threshold value (T_{_th1}, T_{_th2}, T_{_th3}) and the temperature difference threshold value (ΔT_{_th1}, ΔT_{_th2}, ΔT_{_th3}) to values smaller than the initial value, depending on the motor angle. Further, the controller 10 may set the temperature threshold value (T_{_th1}, T_{_th2}, T_{_th3}) so as to match the properties of the temperature difference (ΔTp) shown in Fig. 11.

In a modification of the present embodiment, the controller 10 may set the temperature difference threshold value (ΔT_{_th1}, ΔT_{_th2}, and ΔT_{_th3}) according to the motor torques. The motor torque may be calculated from torque command value corresponding to the accelerator, etc.

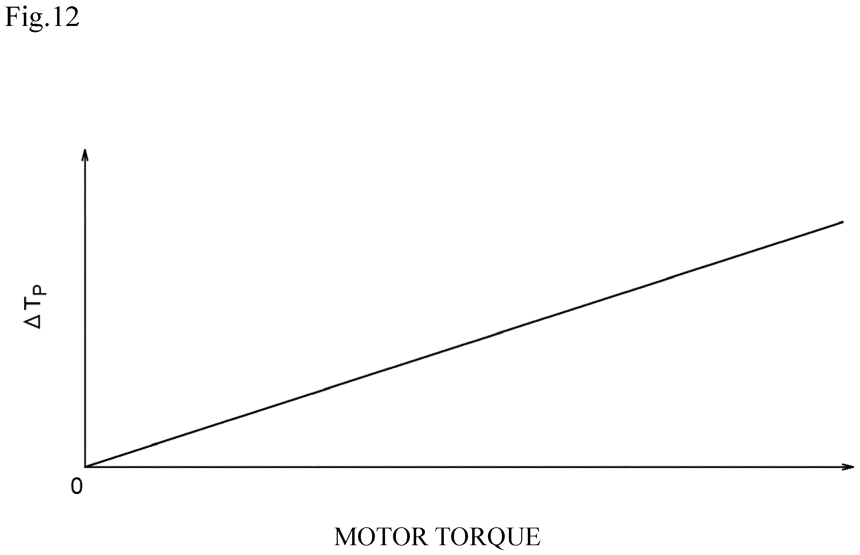

Fig. 12 is a graph showing the relationship between the motor torque and the temperature difference (ΔTp). As shown in Fig. 12, the larger the motor torque, the smaller the temperature difference (ΔTp). That is, there is a relationship between the temperature difference (ΔTp) and the motor torque. The controller sets the temperature threshold value (T_{_th1}, T_{_th2}, T_{_th3}) to a lower value as the motor torque increases. Thus, the area to be restricted and the area to be not restricted can be appropriately set for the operation area of the device. Incidentally, the controller 10 may set the temperature difference threshold value (ΔT_{_th1}, ΔT_{_th2}, ΔT_{_th3}) to a lower value, may set the temperature threshold value (T_{_th1}, T_{_th2}, T_{_th3}) and the temperature difference threshold value (ΔT_{_th1}, ΔT_{_th2}, ΔT_{_th3}) to a lower value as the larger the motor torque.

In a modification of the present embodiment, the controller 10 may set the temperature difference threshold value (ΔT_{_th1}, ΔT_{_th2}, and ΔT_{_th3}) according to the carrier frequency. Carrier frequency is the frequency used for PWM control of inverter. When a sensor of at least one of the device temperature sensor 21u, 21v, and 21w is abnormal, the higher the carrier frequency, the larger the temperature difference (ΔTp). The controller 10 sets the temperature threshold value (T_{_th1}, T_{_th2}, T_{_th3}) to a lower value as the higher the carrier frequency. Thus, the area to be restricted and the area to be not restricted can be appropriately set for the operation area of the device. Incidentally, the controller 10 may set the temperature difference threshold value (ΔT_{_th1}, ΔT_{_th2}, ΔT_{_th3}) to a lower values and may set the temperature threshold value (T_{_th1}, T_{_th2}, T_{_th3}) and the temperature difference threshold value (ΔT_{_th1}, ΔT_{_th2}, ΔT_{_th3}) to a lower values as the higher the carrier frequency.

In a modification of the present embodiment, the controller 10 may set the temperature difference threshold value (ΔT_{_th1}, ΔT_{_th2}, and ΔT_{_th3}) according to the refrigerant temperature. The refrigerant temperature may be obtained from the temperature sensor 22. At lower the refrigerant temperatures, the temperature difference (ΔTp) becomes smaller because of higher cooling performance. The controller 10 sets the temperature threshold value (T_{_th1}, T_{_th2}, T_{_th3}) to a lower value as the refrigerant temperature is higher. Thus, the area to be restricted and the area to be not restricted can be appropriately set for the operation area of the device. Incidentally, the controller 10 may set the temperature difference threshold value (ΔT_{_th1}, ΔT_{_th2}, ΔT_{_th3}) to a lower values and may set the temperature threshold value (T_{_th1}, T_{_th2}, T_{_th3}) and the temperature difference threshold value (ΔT_{_th1}, ΔT_{_th2}, ΔT_{_th3}) to a lower values as the higher the refrigerant temperature.

In a modification of the present embodiment, the controller 10 may set the temperature difference threshold value (ΔT_{_th1}, ΔT_{_th2}, and ΔT_{_th3}) according to the refrigerant flow rate. The refrigerant flow rate may be detected using the flow sensor. When the refrigerant flow rate is large, the temperature difference (ΔTp) becomes small because of the higher cooling performance. The controller 10 sets the temperature threshold value (T_{_th1}, T_{_th2}, T_{_th3}) to a lower value as the refrigerant flow rate is smaller. Thus, the area to be restricted and the area to be not restricted can be appropriately set for the operation area of the device. Incidentally, the controller 10 may set the temperature difference threshold value (ΔT_{_th1}, ΔT_{_th2}, ΔT_{_th3}) to a lower value and may set the temperature difference threshold value (ΔT_{_th1}, ΔT_{_th2}, ΔT_{_th3}) and the temperature threshold value (T_{_th1}, T_{_th2}, T_{_th3}) to a lower value as the smaller the refrigerant flow rate.

In the above modification, motor rotation speed or the like is used as a parameter having the temperature difference (ΔTp) and correlation, but the parameter is not limited to the detected value of sensor, but may be a value based on an estimated value obtained by an operation or a command value corresponding to a system or user operation. The parameter may also be a power supply voltage. In addition, when changing the temperature threshold value (T_{_th1}, T_{_th2}, T_{_th3}) and/or the temperature difference threshold value (ΔT_{_th1}, ΔT_{_th2}, and ΔT_{_th3}), the change timing may be adjusted by a low-pass filter or hysteresis.

### «Forth Embodiment»

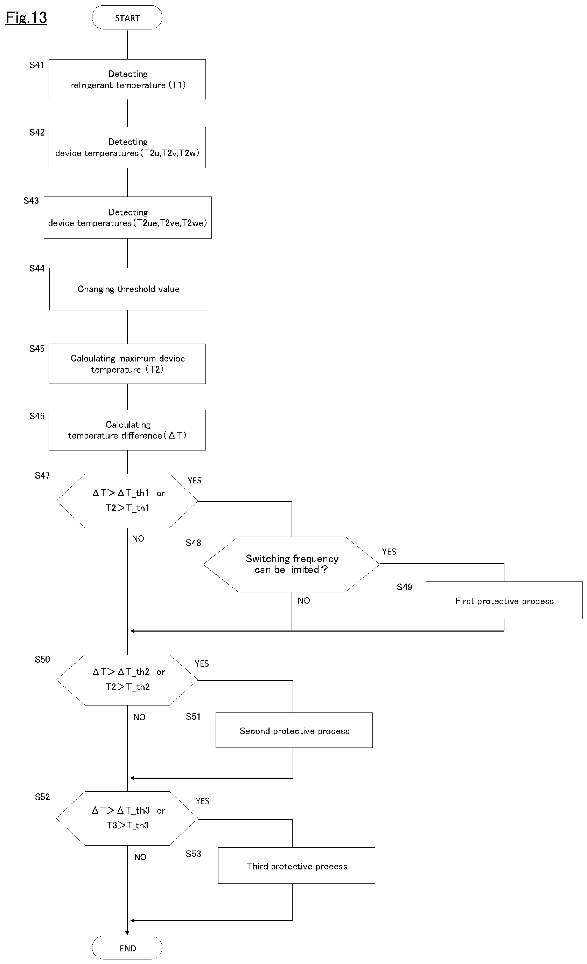

Fig. 13 is a flowchart illustrating a control flow of controller of the device protection apparatus according to another embodiment of the present invention. In the present embodiment, with respect to the first embodiment described above, a part of the control flow is different. Other configurations are the same as those of the first embodiment described above, the description of the first embodiment and the second embodiment is incorporated by reference for the other configurations.

The control flowchart of controller 10 will be described with reference to Fig. 13. The control flows of step S41 and S42 are the same as the control flows of step S1 and S2 described in the first embodiment, and therefore descriptions thereof are omitted. In step S43, the controller 10, based on detected temperature (T2u, T2v, T2w) detected by the device temperature sensors 21u, 21v, and 21w, estimate the temperature of each phase (the device temperature :T2ue, T2ve, T2we). For example, using a chip sensor as the device temperature sensors 21u, 21v, and 21w, even when the chip sensor is provided on the semiconductor chip in the power module, if there is a void in the chip joint solder portion other than the detecting portion of sensor, the temperature difference between sensor detected value and the actual maximum temperature (maximum temperature of the power module) occurs. Therefore, in the present embodiment, the actual temperature is estimated from detected value of the device temperature sensors 21u, 21v, and 21w, thereby reducing the difference between detected value of the sensor and the actual temperature.

In step S44, the controller 10 acquires a parameter such as the motor rotation speed, and changes the temperature threshold value (T_{_th1}, T_{_th2}, T_{_th3}) and/or the temperature difference threshold value (ΔT_{_th1}, ΔT_{_th2}, ΔT_{_th3}) according to the value of the parameter.

The temperature difference between the estimated temperature of each phase and the actual temperature has parameters such as motor speed and correlation. Relationship between the parameter and the temperature difference is the same as the temperature difference (ΔTp) and parameters (motor rotational speed, etc.) shown in the modification of the second embodiment and the second embodiment. For example, when the temperature threshold value (T_{_th1}, T_{_th2}, T_{_th3}) and/or the temperature difference threshold value (ΔT_{_th1}, ΔT_{_th2}, ΔT_{_th3}) is to be changed using the motor rotation speed, the controller 10 performs the following control. The controller 10 acquires the motor rotation speed using the speed sensor of the resolver, etc. The controller 10 sets the temperature threshold value (T_{_th1}, T_{_th2}, T_{_th3}) and/or the temperature difference threshold value (ΔT_{_th1}, ΔT_{_th2}, ΔT_{_th3}) to a lower value as the motor rotation speed is lower. Thus, when the temperature difference between the estimated temperature of each phase and the actual temperature is increased, the temperature threshold value (T_{_th1}, T_{_th2}, T_{_th3}) and/or the temperature difference threshold value (ΔT_{_th1}, ΔT_{_th2}, ΔT_{_th3}) is set to a lower value. Therefore, the drive limitation is applied at a faster timing.

Incidentally, the motor angle, motor torque, carrier frequency, the refrigerant temperature, for parameters such as the flow rate of the refrigerant, similarly to the respective modifications of the second embodiment, the controller 10, depending on the value of the parameter, may be set the temperature threshold value (T_{_th1}, T_{_th2}, T_{_th3}) and/or the temperature difference threshold value (ΔT_{_th1}, ΔT_{_th2}, ΔT_{_th3}).

In step S 45, the controller 10 calculates the highest temperature (maximum device temperature :T2) among the estimated temperatures of the device temperature. Since the control flow of step S 46 to S53 is the same as the control flow of step S4 to S11 shown in the first embodiment, the explanation thereof is omitted. However, the controller 10 executes the first to third protective process using the modified the threshold value when the temperature threshold value (T_{_th1}, T_{_th2}, and T_{_th3}) and/or the temperature difference threshold value (ΔT_{_th1}, ΔT_{_th2}, ΔT_{_th3}) are changed in the control process of step S44.

As described above, the present embodiment, based on the detected device temperature, estimates the device temperature, compares the estimated device temperature with a predetermined threshold value, and applies the drive limitation to the device based on the comparison result. This ensures that the device is adequately protected while suppressing the temperature difference between the detected value of the sensor and the actual temperature.

In the present embodiment, the first protective action applies the drive limitation to the device when the estimated device temperature is higher than the first temperature threshold value, and the second protective action applies the drive limitation to the device when the estimated device temperature is higher than the second temperature threshold value after the first protective action applies the drive limitation to the device. This limits the power that is directly responsible for raising the heat-generation part's temperature and expands the device's operable time. Note that the first temperature threshold value corresponds to the temperature threshold value (T_{_th1}) or the temperature threshold value (T_{_th2}), the second temperature threshold value corresponds to the temperature threshold value (T_{_th2}) or the temperature threshold value (T_{_th3}), the first protective action corresponds to the first protection process or the second protection process, the second protective action corresponds to the second protection process or the third protection process.

In the present embodiment, in accordance with the estimated the device temperature, the threshold value of at least one of the temperature difference threshold value and the temperature threshold value is set. Thus, when difference between the estimated temperature and the actual temperature are large, the drive limitation can be applied at a faster timing by setting the threshold value to a lower value.

In the present embodiment, the temperature threshold value (T_{_th1}, T_{_th2}, T_{_th3}) and/or the temperature difference threshold value (ΔT_{_th1}, ΔT_{_th2}, ΔT_{_th3}) are set according to the parameters of the motor rotation speed or the like. Thus, when the difference between the detected value or the estimated temperature of each phase of the device temperature sensor 21u, 21v, 21w, and the actual maximum temperature is increased, by setting the threshold value to a lower value, it is possible to apply the drive limitation at a faster timing. In addition, when the difference between the detected values of the device temperature sensor 21u, 21v, and 21w or the estimated temperatures of each phase and the actual maximum temperature becomes small, by increasing the threshold value, it is possible to appropriately set the area to be limited and the area to be not limited for the operation area of the device. In the present embodiment, instead of changing the threshold value, the detected value of sensor may be changed.

### [Description of Reference Numerals]

- 1: Power source
- 2: Load
- 3: Power converter
- 4: Cooling device
- 10: Controller
- 21, 22: Temperature sensor
- 21u, 21v, 21w: Device temperature sensor

## Claims

1. A device protection apparatus comprising:
a refrigerant temperature sensor for detecting a temperature of a refrigerant used for cooling a device including a heat-generation part;
a plurality of device temperature sensors for detecting a temperature of the device;
a controller that applies drive limitation to the device based on a detected refrigerant temperature detected by the refrigerant temperature sensor and a detected temperature detected by the device temperature sensors,
wherein the controller,
specifies the detected temperature higher than the lowest detected temperature among the temperatures detected by the plurality of the device temperature sensors, as a detected device temperature,
calculates a temperature difference between the detected refrigerant temperature and the detected device temperature,
applies the drive limitation to the device when the temperature difference is higher than a temperature difference threshold value, and
applies the drive limitation to the device when the detected device temperature is higher than a temperature threshold value.

2. The device protection apparatus according to claim 1,
wherein the controller,
determines whether or not the device temperature sensor is abnormal based on the detected temperature detected by the device temperature sensors, and
specifies the detected device temperature from among the temperatures detected by the device temperature sensor in which no abnormality is occurred when determining that at least one of the plurality of the device temperature sensors is abnormal.

3. The device protection apparatus according to claim 2,
wherein the controller lowers a threshold value of at least one of the temperature difference threshold value and the temperature threshold value lower than an initial set value or raises a detected value of the device temperature sensor in which no abnormality is occurred higher than a normal detected value, when determining that at least one of the plurality of the device temperature sensors is abnormal.

4. The device protection apparatus according to claim 2,
wherein the controller sets at least one of the temperature difference threshold value and the temperature threshold value to a threshold value in accordance with a temperature difference between a detected temperature of the device temperature sensor in which abnormality is occurred and a detected temperature of the device temperature sensor in which no abnormality is occurred.

5. The device protection apparatus according to claim 2,
wherein the controller sets at least one of the temperature difference threshold value and the temperature threshold value to a threshold value in accordance with a motor rotation speed, when determining that at least one of the plurality of the device temperature sensors is abnormal.

6. The device protection apparatus according to claim 2,
wherein the controller sets at least one of the temperature difference threshold value and the temperature threshold value to a threshold value in accordance with a motor angle, when determining that at least one of the plurality of the device temperature sensors is abnormal.

7. The device protection apparatus according to claim 2,
wherein the controller sets at least one of the temperature difference threshold value and the temperature threshold value to a threshold value in accordance with a motor torque, when determining that at least one of the plurality of the device temperature sensors is abnormal.

8. The device protection apparatus according to claim 2,
wherein the controller sets at least one of the temperature difference threshold value and the temperature threshold value to a threshold value in accordance with a career frequency, when determining that at least one of the plurality of the device temperature sensors is abnormal.

9. The device protection apparatus according to claim 2,
wherein the controller sets at least one of the temperature difference threshold value and the temperature threshold value to a threshold value in accordance with the temperature of the refrigerant, when determining that at least one of the plurality of the device temperature sensors is abnormal.

10. The device protection apparatus according to claim 2,
wherein the controller sets at least one of the temperature difference threshold value and the temperature threshold value to a threshold value in accordance with a refrigerant flow rate of the refrigerant, when determining that at least one of the plurality of the device temperature sensors is abnormal.

11. The device protection apparatus according to any one of the claims 1 to 10, wherein
the temperature threshold value includes a first temperature threshold value and a second temperature threshold value, and
the controller,
applies the drive limitation to the device by a first protective action when the detected device temperature is higher than the first temperature threshold value, and
applies the drive limitation to the device by a second protective action when the detected device temperature is higher than the second temperature threshold value after applying the drive limitation to the device by the first protective action.

12. The device protection apparatus according to any one of the claims 1 to 10, wherein
the temperature threshold value includes a first temperature threshold value and a second temperature threshold value, and
the controller,
applies the drive limitation to the device by a first protective action when the temperature difference is higher than the first temperature threshold value, and
applies the drive limitation to the device by a second protective action when the temperature difference is higher than the second temperature threshold value after applying the drive limitation to the device by the first protective action.

13. The device protection apparatus according to any one of the claims 1 to 10, wherein the controller,
estimates a temperature of the device based on the detected device temperature,
compares the estimated device temperature with the temperature threshold value, and
applies the drive limitation to the device based on the compared result.

14. The device protection apparatus according to claim 13, wherein
the temperature threshold value includes a first temperature threshold value and a second temperature threshold value, and
the controller
applies the drive limitation to the device by a first protective action when the estimated device temperature is higher than the first temperature threshold value, and
applies the drive limitation to the device by a second protective action when the estimated device temperature is higher than the second temperature threshold value after applying the drive limitation to the device by the first protective action.

15. The device protection apparatus according to claims 13 or 14,
wherein the controller sets at least one of the temperature difference threshold value and the temperature threshold value to a threshold value in accordance with the estimated device temperature.

16. A device protection method for protecting a device by using a refrigerant temperature sensor for detecting a temperature of a refrigerant used for cooling a device including a heat-generation part, a plurality of device temperature sensors for detecting a temperature of the device, and a controller, the method of comprising:
specifying a detected temperature higher than the lowest detected temperature among the temperatures detected by the plurality of the device temperature sensors, as a detected device temperature;
calculating a temperature difference between the detected refrigerant temperature and the detected device temperature;
applying the drive limitation to the device when the temperature difference is higher than a temperature difference threshold value; and
applying the drive limitation to the device when the detected device temperature is higher than a temperature threshold value.
